(19) Europäisches Patentamt
European Patent Office
Office européen des brevets

(11) EP 1 304 740 A2

(12) EUROPEAN PATENT APPLICATION

(43) Date of publication:
23.04.2003 Bulletin 2003/17

(51) Int Cl.⁷: H01L 23/498, H01L 23/66

(21) Application number: 02254288.0

(22) Date of filing: 20.06.2002

| | |
|---|---|
| (84) Designated Contracting States:<br>**AT BE CH CY DE DK ES FI FR GB GR IE IT LI LU<br>MC NL PT SE TR**<br>Designated Extension States:<br>**AL LT LV MK RO SI**<br><br>(30) Priority: **17.10.2001 JP 2001319493**<br><br>(71) Applicant: **SUMITOMO ELECTRIC INDUSTRIES,<br>LTD.**<br>**Osaka-shi, Osaka (JP)** | (72) Inventors:<br>• **Tatoh, Nobuyoshi**<br>**1-1. Koyakita 1-chome, Itami-shi, Hyogo (JP)**<br>• **Yorita, Jun,**<br>**Harima R&D Lab. of Sumitomo Elec. Ind<br>Ako-gun, Hyogo (JP)**<br><br>(74) Representative:<br>**Cross, Rupert Edward Blount et al<br>BOULT WADE TENNANT,<br>Verulam Gardens<br>70 Gray's Inn Road<br>London WC1X 8BT (GB)** |

(54) **Circuit board, method for manufacturing same, and high-output module**

(57)    A circuit board comprising a patterned first metal layer 14 formed on a ceramic substrate 11, a patterned second metal layer 16 formed on the first metal layer, and a third metal layer 17 formed covering the entire upper surface and side surfaces of the second metal layer and a part of the upper surface of the first metal layer, wherein portions of the first metal layer not covered by the third metal layer are reduced in width by etching. The circuit board has thick-film fine wiring patterns with high bonding strength between the wiring patterns and the substrate and high reliability and enables realization of high-output modules which are small in size and high in performance, by mounting at least one high-output semiconductor element thereon.

FIG. 3

**Description**

The present invention relates to a ceramic circuit board for a semiconductor device, and to a method for manufacturing this circuit board, and to a high-output module.

Semiconductor elements include LD (laser diode or semiconductor laser), APD (avalanche photodiodes), and other such optical semiconductor elements; HEMT (high electron mobility transistor), HBT (hetero-bipolar transistor), and other such semiconductor elements using GaAs, InP, Si/SiGe, or the like that can operate at high speed; IGBT (insulated gate bipolar transistor) and other such inverter/power converter silicon devices; and BiTe and other such thermoelectric semiconductor elements, and the circuit boards used in these fields need to have low electrical resistance, good thermal radiation, well-matched thermal expansion, and a fine wiring pattern for higher integration and speed.

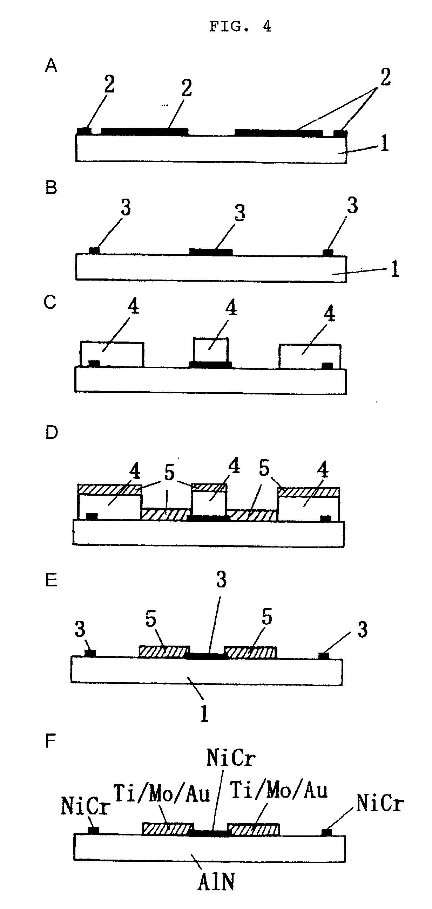

A conventional circuit board will be described through reference to Figs. 4A-4F. As shown in Figs. 4A-4E the process has been as follows up to now. A metal mask or photomask 2 is applied on a ceramic substrate 1 (Fig. 4A), a first metal layer 3 is formed by vapor deposition or sputtering, and the metal mask or photomask 2 is removed (Fig. 4B), after which a resist 4 is formed (Fig. 4C), and then a second metal layer 5 is formed by vapor deposition or sputtering (Fig. 4D), and the resist is removed to obtain a completed product (Fig. 4E).

The ceramic substrate 1 is made from AlN or alumina. This is disclosed, for instance, in Japanese Patent Publication 2-271585. The first metal layer is used for a resistor, and TaN, NiCr, or tungsten is generally used therein. The second metal layer is used for a wiring or an inductance, and has a laminate structure comprising Ti/Mo/Au, Ti/Pt/Au, Cr/Mo/Au, or Ti/V/Au. The reason for using titanium or chromium for the layer in contact with the ceramic substrate is to increase the adhesion strength to the substrate. Because the platinum, molybdenum, or vanadium in the middle has a high melting point, it is inserted in order to prevent the top layer from alloying with the metal, i.e., titanium or chromium used in the above contact portion. Gold is used for the top layer, and is selected in order to successfully perform wire bonding or die bonding. An example of the combination of materials in the completed product is shown in Fig. 4F.

With a circuit board for a power semiconductor, copper or gold is applied to the entire upper surface of a ceramic substrate by vapor deposition, plating, or fusion, after which a wiring pattern is formed by etching.

To produce a high-output module, semiconductor elements are mounted on these circuit boards by means of die bonding.

With today's high-output modules, in addition to making the modules smaller merely to reduce the size of the final device, there is also the need to make the wiring patterns much finer with a reduced size so that higher frequencies can be handled. It is also necessary to lower the resistance of the metal portion for wiring in order to reduce loss of high frequency characteristics and decrease power consumption, and to this end thick-film techniques have become necessary to increase the thickness of the wiring patterns.

To satisfy both of these requirements at the same time, it was necessary for the thickness of the metal layer used for wiring to be at least 5 $\mu$m, and for the aspect ratio (D/L) between the wiring thickness D ($\mu$m) and the distance L ($\mu$m) between the adjacent wiring pattern lines to be D/L > 0.4, but a conventional circuit board could not be processed so that both of these could be satisfied.

The reason for this is that a fine pattern could not be formed on a substrate, onto which a thick film resist has been applied, with a vapor deposition process relying on a metal mask or photomask, which is a conventionally practiced fine wiring process, and that vapor deposition had to be continued for a long time in order to obtain a thick film, so practical application was difficult. Also, when a wiring pattern was formed by etching, it was difficult to perform fine processing of a pattern smaller than the wiring thickness because side etching occurred, and etching removal was particularly difficult. Consequently, a miniaturized high-performance high-output module could not be realized.

The inventors of this invention, in Japanese Patent Application 2001-204457, have proposed a circuit board having thick film and fine wiring patterns, as well as a miniature high-performance high-output module. However, in this circuit board, the strength of the bonding between the wiring pattern and the substrate was inadequate.

The problem addressed by this invention is provision of a circuit board that has thick-film fine wiring patterns and realizes high bonding strength between the wiring patterns and the substrate and high reliability, as well as achievement of a miniature high-performance high-output module.

In order to solve the above problems, the present invention is constituted as follows.

[1] A circuit board comprising a patterned first metal layer formed on a ceramic substrate, a patterned second metal layer formed on the first metal layer, and a third metal layer formed covering the entire upper surface and the side surfaces of the second metal layer and a part of the upper surface of the first metal layer, wherein portions of the first metal layer not covered by the third metal layer are reduced in width by etching.

[2] The circuit board according to [1] above, wherein the combined thickness D ($\mu$m) of the first, second, and third metal layers and the distance L ($\mu$m) between adjacent pattern lines satisfy the relationship of the following formula.

$$D/L > 0.4$$

[3] The circuit board according to [1] or [2] above, wherein the width (L1) of the second metal layer and the width (L2) of the third metal layer, and the width (L3) of the connecting surface portion between the first metal layer and the ceramic substrate satisfy the relationship L1 < L3 < L2.

[4] The circuit board according to any of [1] to [3] above, wherein the combined thickness D ($\mu$m) of the first, second, and third metal layers is at least 5 $\mu$m.

[5] The circuit board according to any of [1] to [4] above, wherein the second metal layer includes at least one selected from the group consisting of copper, nickel, silver, and aluminum.

[6] The circuit board according to any of [1] to [5] above, wherein the outermost layer of the third metal layer is gold.

[7] The circuit board according to any of [1] to [6] above, wherein the ceramic substrate contains at least one selected from the group consisting of alumina, AlN, and $Si_3N_4$ in an amount of at least 90 wt%.

[8] The circuit board according to any of [1] to [6] above, wherein the ceramic substrate is diamond or cBN.

[9] A method for manufacturing the circuit board according to any of [1] through [8] above, the method comprising:

(1) forming a first metal layer on a ceramic substrate by vapor depositing or sputtering;
(2) forming a resist in patterns;
(3) applying a second metal layer on the first metal layer by plating using the resist as a mask;
(4) shrinking the resist by maintaining the resist at a high temperature;
(5) applying a third metal layer on the upper surface and side surfaces of the second metal layer and a part of the upper surface of the first metal layer by plating;
(6) removing the resist; and
(7) etching the first metal layer so that portions of the first metal layers not covered by the third metal layer is reduced in width by etching.

[10] A method for manufacturing the circuit board according to any of [1] through [8] above, the method comprising:

(1) forming a first metal layer on a ceramic substrate by vapor depositing or sputtering;
(2) forming a resist in patterns;
(3) applying a second metal layer on the first metal layer by plating using the resist as a mask;
(4) shrinking the resist by maintaining the resist at a high temperature;
(5) widening the space between the resist and the second metal layer;
(6) applying a third metal layer on the upper surface and side surfaces of the second metal layer and a part of the upper surface of the first metal layer by plating;
(7) removing the resist; and
(8) etching the first metal layer so that portions of the first metal layers not covered by the third metal layer is reduced in width by etching.

[11] A high-output module, wherein at least one high-output semiconductor element that generates a heat of at least 10 mW is joined on the circuit board according to any of [1] to [8] above via a solder or an electrically conductive resin.

Figs. 1A and 1B are cross sections illustrating an example of the wiring in the circuit board of the present invention.

Figs. 2A to 2I are explanatory diagrams illustrating the steps for manufacturing a circuit board in an example of the present invention and Fig. 2J is an explanatory diagram showing the material of each of the parts which constitute the circuit board obtained as shown in Figs. 2A to 2I.

Fig. 3 is a diagram of the structure of the high-output module produced in an example.

Figs. 4A to 4E are explanatory diagrams illustrating the steps for manufacturing a conventional circuit board and Fig. 4F is an explanatory diagram showing a combination of materials in the completed circuit board.

The circuit board of the present invention is manufactured as follows. First, onto a ceramic substrate a first metal layer with good adhesion to the substrate, such as Ti/Mo/Ni, is applied by vapor deposition or sputtering. A photoresist pattern is formed on this first metal layer using a photomask. In this state the entire surface of the substrate can serve as an electrode, so a second metal layer can be selectively formed in a thick film by electroplating in the places where there is no photoresist.

Next, the resist is maintained at a high temperature. By maintaining the resist at a high temperature, the resist shrinks and gaps are formed between the side surfaces of the second metal layer and the side surfaces of the resist. Then, after causing such gaps to form, upon executing the next process step of forming the third metal layer, a coating is formed by the third metal layer on the upper surface of the second metal layer, and also on the sides of the second metal layer and the upper surface of the first metal layer which have been exposed by the gaps. In this way, the width of the third metal layer can be made one level bigger than the width of the second metal layer. Throughout the specification of this application, the term, "width of the third metal layer," means the width of the sum of the width of the second metal layer and the width of the third metal layer formed on the first metal layer. The environment during maintenance of this high temperature may be anything, as long as the environment does not deteriorate the Cu or resist, and is preferably a vacuum or inactive gas environment. The temperature during this maintenance of high temperature is preferably 60 to 100°C, and the resulting shrinkage will cause gaps of 1 to 10μ to be formed.

Next, a third metal layer, for example, Au, Ni/Au, or a multilayer structure in which an intermediate layer (an Au diffusion-preventing layer) of Pd, Pt, Mo, W, V, etc. is inserted between the Ni and Au layers, such as Ni/Pt/Au, etc. is grown on the second metal layer by electrolytic plating. At this time, the plating liquid also enters the gap formed by the resist shrinkage in an earlier process step, so the third metal layer is formed on the upper surface and side surfaces of the second metal layer and on a part of the upper surface of the first metal layer.

Next, after resist removal, the areas of the first metal layer which is not covered by the third metal layer is removed by etching. Here, by making the outermost layer of the third metal layer from a material which will not be etched by an etching liquid for the first metal layer, the areas covered by the third metal layer will not be etched during etching, thus enabling etching to be done selectively. For example, by making the outermost layer of the third metal layer of Au and making the first metal layer of Ti/Mo/Ni, the Au will not be etched by an etching liquid for Ni and Mo, and therefore etching can be done using the plated Au as a mask. Moreover, Ti can be dissolved only by a separate hydrofluoric acid type etching liquid. Au, however, will not be etched even by such an etching liquid, so the Au outmost layer functions as a mask and selective etching can be done.

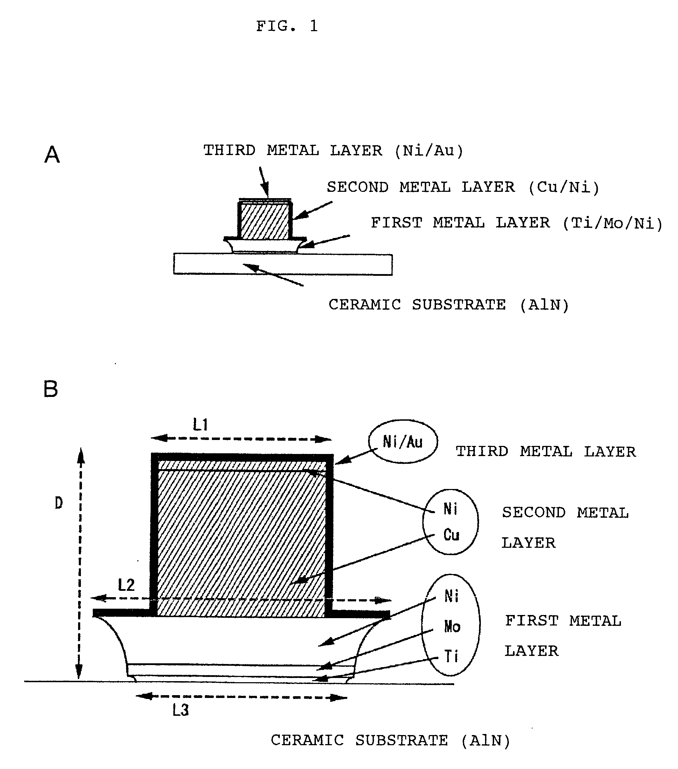

One example of the layer configuration of the metal layers of a circuit board obtained in this way is shown in Figs. 1A and 1B. The side surfaces of the first metal layer which are not covered by the Au of the third metal layer are carved out in a gently-sloping undercut pattern, and the carving out of the Ti layer is even greater.

As shown in Fig. 1B, by using the above manufacturing process, the width (L2) of the third metal layer is formed larger than the width (L1) of the second metal layer, that is, (L1 < L2). As a result, it is possible to prevent the width (L3) of the first metal layer at the area in contact with the ceramic substrate from becoming small through etching. In this way, it is possible to maintain the bonding strength between the ceramic substrate and the second metal layer (for example, Cu wiring) at 0.5 kgf/mm$^2$ or more, even at temperatures of 830°C as occurs in silver soldering.

In the written specification of this application, the above-mentioned "width (L1) of second metal layer" means a dimension that includes the thickness of the third metal layer formed on the side surfaces of the second metal layer.

In the above-mentioned manufacturing method, after maintaining the substrate at high temperature and making the resist shrink, the third metal layer is formed. However, in some case, it is not possible to make the width (L2) of the third metal layer sufficiently large because it is difficult to form an adequate gap only through resist shrinkage. In such a case, to make the width (L2) of the third metal layer sufficiently large, a step of widening the space between the resist and the second metal layer such as a resist ashing step may be added between the resist shrinking step and the third metal layer forming step.

Through this resist ashing, the size of the gap formed by resist shrinkage can be further widened and the surface area of the first metal layer covered by the third metal layer through plating can be further increased, so that the width (L2) of the third metal layer can be made sufficiently large. As a result, the width (L3) of the bonding surface between the first metal layer, formed through etching, and the ceramic substrate can be made larger than the width (L1) of the second metal layer (L1 < L3 < L2) and the bonding strength between the ceramic substrate and the second metal layer (for example, Cu wiring) via the first metal layer can be increased to 0.6 kgf/mm$^2$ or more.

Through ashing, the gap can be made as large as necessary, and it is acceptable to form a gap of up to 200 μm. In practice, a gap on the order of 100 μm is good.

For the above manufacturing method, the case of forming the first metal layer directly on the ceramic substrate was discussed. However, resistors or patterned metallization (lowest layer metal layer) of Cr-type material, such as NiCr, etc., for positioning a photomask can be made ahead of time on the ceramic substrate, and this is also within the scope of the invention of this application. Because the lowest layer metal layer is not etched by any etching liquid, it remains until the end. In addition, its adhesion to the ceramic substrate is good.

According to the present invention, the second metal layer can be formed by electrolytic plating, so it is easy to make the metal layer a thick film. In addition, as mentioned above, by covering the upper surface and side surfaces of the second metal layer with the third metal layer which has an outer layer that is not etched by the first metal layer etching liquids, wiring pattern formation can be done by etching.

Moreover, because one can make the width (L3) of the connecting surface of the first metal layer and the ceramic substrate large after etching, it is possible to make the bonding strength between the ceramic substrate and the second metal layer (for example, copper wiring) through the first metal layer even greater.

As the first metal layer, a multilayer constitution such as Ti/Mo/Ni, Ti/Pt/Ni, Ti/V/Ni, Ti/Pd/Ni, etc. may be used. A first metal layer thickness of 0.12 to 1.2 μm is preferable. If it is thinner, it is difficult to achieve uniform metallization over the whole surface, while if it is thicker, "side etching" during etching increases and it becomes difficult to achieve the formation of fine patterns of high resolution. When the first metal layer is constituted of Ti/Mo/Ni, Ti thickness of 0.01 μm to 0.3 μm, Mo thickness of 0.01 μm to 0.3 μm, and Ni thickness of 0.1 μm to 0.6 μm are desirable.

It is desirable that the thickness of the resist formed over the first metal layer be 5 μm or more, in order to make a total thickness of the first, second and third metal layers of 5 μm or more. It is undesirable for the resist to be too thin because the second metal layer could then ride over the resist and undesirable mushroom shapes could be formed excessively on the resist with the result that adjacent sections of the metal layer might even connect over the resist. It was difficult to make the resist thick, but by optimizing the exposure conditions, it was possible to achieve thick films and fine wiring patterns with straight upright side surfaces can be formed. For exposure, A SOR (synchrotron orbital radiation) light was used. Thanks to the formation of the thick film resist, it was possible to suppress the formation of mushroom shapes.

The precision of photoresist patterns for electrolytic plating is from submicron to 10 nm. By using a surface active agent, even plating of extremely narrow parts between photoresist patterns is possible.

With circuit boards according to the present invention, it is preferable that the second metal layer include at least one material selected from among Cu, Ni, Ag and Al. Thick films with a thickness of 5 μm or greater can be formed by means of electrolytic plating. Even a thickness of 200 μm, for example, is possible. By making the thickness of the second metal layer greater than 5 μm, the resistance of the wiring can be reduced and this is ideal for thermoelectric semiconductor elements, such as Peltier elements, for example, which require thick wiring to relieve thermal stress. As examples of second metal layers, the following can be noted: Cu, Cu/Ni, Ni/Cu/Ni, Al, Ni/Al/Ni, Al/Ni, Ag, etc. A single layer of Cu would be acceptable if alloy processing were introduced later to increase the bonding strength, and if a Ni layer with a thickness of 0.5 μm or more is formed on the upper surface of the Cu layer, the adhesion of the second metal layer to Au or Ni/Au of the third layer is improved.

For the third metal layer, any of the following can be used: Au, Ni/Au, or a multilayer structure with an intermediate layer (an Au diffusion prevention layer) of Pd, Pt, Mo, W, or V inserted between Ni and Au layers, such as Ni/Pt/Au, etc. As the outermost layer of the third metal layer, any material which is not etched by an etching liquid for the first metal layer is acceptable, but layers wherein the outermost layer is Au are preferable because later processing can be readily done.

In the circuit board of the present invention, thick film metal layers can be achieved because the second metal layer can be formed through electrolytic plating, and, because fine wiring patterns with vertical side surfaces can be formed by means of resist, the structure can be formed such that the aspect ratio (D/L) of the wiring thickness D (μm) and the spacing between wiring pattern lines L (μm) becomes D/L > 0.4. In this invention, the wiring thickness D is the total thickness of the first, second and third metal layers, and the spacing between pattern lines L indicates the distance between pattern lines in the second metal layer which are covered by the third metal layer.

For the ceramic substrate, alumina may be used, but for high output modules, heat dissipation is important, so diamond, cBN, or materials comprising AlN and/or $Si_3N_4$ in an amount of 90 wt % or more are preferable. AlN is the lowest cost substrate and also has high resistance to leakage. In cases where strength is needed, it is desirable to use $Si_3N_4$. A mixture of AlN and $Si_3N_4$ may also be used. If the substrate surface is too rough, depending on the relationship to the thickness of the first metal layer formed on the substrate, line disruption may occur, so to prevent that, surface treatment may be performed.

The present invention also covers high-output modules wherein at least one high-output semiconductor element generating a heat of 10 mW or more is attached, by means of solder or conductive resin, to a circuit board obtained as described above.

Below are described embodiments of the present invention based on Figs. 1 through 3.

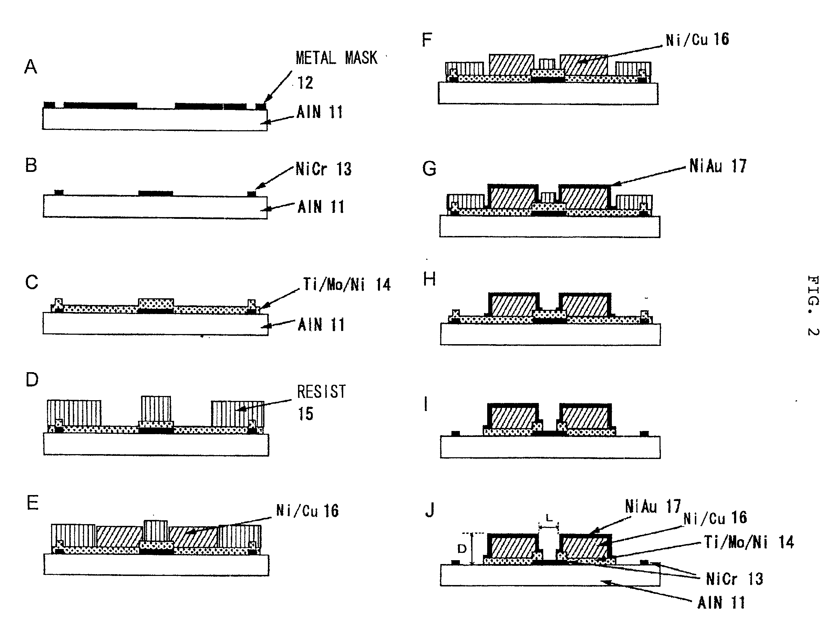

Figs. 2A to 2I are diagrams that describe an embodiment of the present invention in order of the process steps. The step shown in Fig. 2E is adopted in Example 2, but is not adopted in Example 1.

**Example 1**

As shown in Fig. 2A, a ceramic substrate comprising AlN in an amount of 90 wt % or higher and further including Y was used as the ceramic substrate 11. This substrate had a high heat dissipation substrate with a coefficient of thermal conductivity of 170 W/ (m·k). A metal mask 12 was applied onto it. The ceramic substrate 11 was surface treated to a surface roughness Ra of under 0.8 μm. This is because the first metal layer which will be formed next is less than 0.5 μm thick, so if the substrate is too rough, line disruption may occur.

Next, a NiCr metal layer was formed as the lowest metal layer 13 through vapor deposition. This metal layer 13 was used as a resistor or as a positioning mark in the later step of dicing the circuit board, and here NiCr was selected for use as a resistor. Fig. 2B shows the situation wherein, after removing a metal mask 12, the pattern of the NiCr, which was the lowest layer metal layer 13, had been formed on the surface of the ceramic substrate 11.

Next, as shown in Fig. 2C, Ti/Mo/Ni layers were vapor deposited as the first metal layer 14 on the entire upper surface of the ceramic substrate 11. The thickness of the Ti layer was set at 0.05 μm, the thickness of the Mo layer at 0.05 μm, and the thickness of the Ni layer at 0.3 μm.

As shown in Fig. 2D, over the thus metallized substrate, a resist 15 was formed using a photomask. The thickness of the resist 15 was set at 120 μm to match the thickness of the second metal layer 16.

Next, as shown in Fig. 2E, a multilayer of Ni/Cu was laminated as the second metal layer 16 by electrolytic plating. For good adhesion of the plating, the thickness of the Ni layer was set at 0.5 µm and that of the Cu layer at 100 µm.

Next, the above-mentioned ceramic substrate having the second metal layer 16 and the resist 15 was maintained for 30 minutes under high temperature conditions of 85°C in a nitrogen atmosphere.

Through this heating, the resist shrank and a gap of 5 µm was formed between the side surface of second metal layer 16 and the side surface of resist 15 as shown in Fig. 2F.

Next, as shown in Fig. 2G, a multilayer of Ni/Au was plated as the third metal layer 17 and this Ni/Au third metal layer covered the upper surface of the second metal layer and also the side surfaces of the second metal layer and the upper surface of the first metal layer which were exposed by the gap. The thickness of the Ni layer was set at 1.3 µm and that of the Au layer at 1.0 µm.

After forming the third metal layer 17, the resist 15 was removed as shown in Fig. 2H and the Ti, Ni, Mo was etched as in Fig. 2I. Here, when the resist was removed, a Ni oxide film formed on the surface, so after that was removed, the Ni and Mo were etched in one step with a reactive etching liquid and the Ti was removed with a hydrofluoric acid etching liquid.

The total thickness of the first, second and third metal layers, D (µm) was 100 µm and the spacing between the pattern lines L (µm) was 40 µm.

The material of each of the parts which constitute the circuit board thus obtained is as shown in Fig. 2J of Fig. 2. The resistance value between the wirings was 1 MΩ or higher, indicating that a circuit board with excellent insulation character had been achieved. In addition, the bonding strength between the AlN substrate and the Cu wiring was good, the conventional value of 0.4 kgf/mm$^2$ being improved to 0.5 kgf/mm$^2$.

## Example 2

Example 2 was implemented in the same way as described in Example 1, except that between the process step of shrinking the resist by maintaining it at a high temperature and the process step of forming the third metal layer, a process step of oxygen ashing was done until the gap created by the above-mentioned shrinking reached 100 µm.

The resistance value between the wiring lines was 1 MΩ or higher, indicating that a circuit board with excellent insulation character had been achieved. In addition, the bonding strength between the AlN substrate and the Cu wiring was improved to 0.6 kgf/mm$^2$ which is superior to that of Example 1.

## Example 3

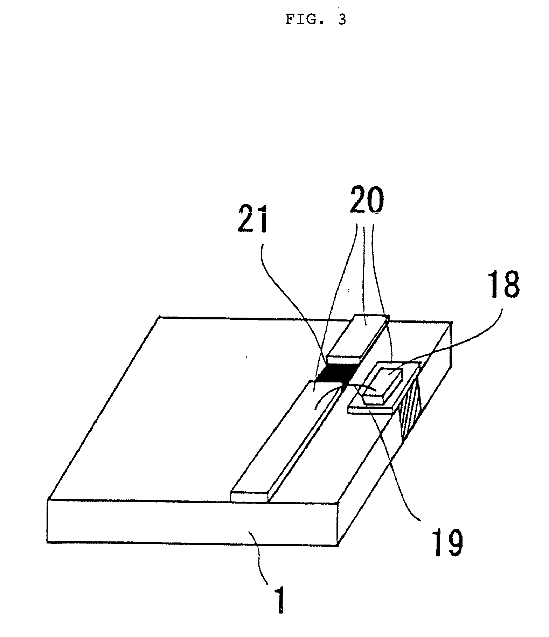

Using the process shown in above-mentioned Example 1, a circuit board having the pattern shown in Fig. 3 was built. Here, for a wiring layer 20, the first metal layer was constituted of Ti/Mo/Ni, the second metal layer was constituted of Ni/Cu, the third metal layer was composed of Ni/Au, and the resistor layer 21 was constituted of Ni/Cr. As shown in Fig. 3, a high-output module was produced by die bonding onto the above circuit board a high-output LD (semiconductor laser) 18, which integrated a modulator and had a heat-generation value of 10 mW or more, and wire bonding with a bonding wire 19. After the mounting step, the module was operated and the SN ratio of the modulation characteristic was improved by 0.1 dB as compared to the case of using a conventional circuit board. The size of the circuit board for mounting the LD could be reduced to 1/4 of the conventional size and the high speed limit increased to 40 Gbps or more.

The metal layers were formed on one side of the ceramic substrate in the above examples, but can also be applied to both sides at the same time.

The present invention makes it possible to obtain a circuit board having thick-film, fine wiring patterns with high bonding strength between the wiring patterns and the substrate and high reliability. In addition, high-output modules can be achieved which are small in size and offer high performance.

## Claims

1. A circuit board comprising a patterned first metal layer formed on a ceramic substrate, a patterned second metal layer formed on the first metal layer, and a third metal layer formed covering the entire upper surface and side surfaces of the second metal layer and a part of the upper surface of the first metal layer, wherein portions of the first metal layer not covered by the third metal layer are reduced in width by etching.

2. The circuit board according to claim 1, wherein a combined thickness D µm of the first, second, and third metal layers and a distance L µm between adjacent pattern lines satisfy the relationship of the following formula.

$$D/L > 0.4$$

3. The circuit board according to claim 1 or 2, wherein the width L1 of the second metal layer, and the width L2 of the third metal layer, and the width L3 of the connecting surface portion between the first metal layer and the ceramic substrate satisfy the relationship L1 < L3 < L2.

4. The circuit board according to any of claims 1 to 3, wherein the combined thickness D µm of the first, second, and third metal layers is at least 5 μm.

5. The circuit board according to any of claims 1 to 4, wherein the second metal layer includes at least one selected from the group consisting of copper, nickel, silver, and aluminum.

6. The circuit board according to any of claims 1 to 5, wherein the outermost layer of the third metal layer is gold.

7. The circuit board according to any of claims 1 to 6, wherein the ceramic substrate contains at least one selected from the group consisting of alumina, AlN, and $Si_3N_4$ in an amount of at least 90 wt%.

8. The circuit board according to any of claims 1 to 6, wherein the ceramic substrate is diamond or cBN.

9. A method for manufacturing the circuit board according to any of claims 1 through 8, the method comprising:

   forming a first metal layer on a ceramic substrate by vapor depositing or sputtering;
   forming a resist in patterns;
   applying a second metal layer on the first metal layer by plating using the resist as a mask;
   shrinking the resist by maintaining the resist at a high temperature;
   applying a third metal layer on the upper surface and side surfaces of the second metal layer and a part of the upper surface of the first metal layer by plating;
   removing the resist; and
   etching the first metal layer so that portions of the first metal layer not covered by the third metal layer is reduced in width by etching.

10. A method for manufacturing the circuit board according to any of claims 1 through 8, the method comprising:

   forming a first metal layer on a ceramic substrate by vapor depositing or sputtering;
   forming a resist in patterns;
   applying a second metal layer on the first metal layer by plating using the resist as a mask;
   shrinking the resist by maintaining the resist at a high temperature;
   widening the space between the resist and the second metal layer;
   applying a third metal layer on the upper surface and side surfaces of the second metal layer and a part of the upper surface of the first metal layer by plating;
   removing the resist; and
   etching the first metal layer so that portions of the first metal layer not covered by the third metal layer is reduced in width by etching.

11. A high-output module, wherein at least one high-output semiconductor element that generates a heat of at least 10 mW is joined on the circuit board according to any of claims 1 to 8 via a solder or an electrically conductive resin.

FIG. 1

A — THIRD METAL LAYER (Ni/Au)

SECOND METAL LAYER (Cu/Ni)

FIRST METAL LAYER (Ti/Mo/Ni)

CERAMIC SUBSTRATE (AlN)

B

L1

Ni/Au — THIRD METAL LAYER

D

Ni
Cu — SECOND METAL LAYER

L2

Ni
Mo
Ti — FIRST METAL LAYER

L3

CERAMIC SUBSTRATE (AlN)

FIG. 2

FIG. 3

FIG. 4

A

2　2　2

1

B

3　3　3

1

C

4　4　4

D

4　5　4　5　4

E

3　5　3　5　3

1

F

NiCr

Ti/Mo/Au　Ti/Mo/Au

NiCr　NiCr

AlN